# EUROPEAN PATENT APPLICATION

(11) **EP 2 252 134 A2**
(43) Date of publication of application: **17.11.2010**
(21) Application number: 10160477.5
(22) Date of filing: 20.04.2010
(51) Int. Cl.: H05K 3/28, G11C 5/00

(54) **Miniature-sized storage device**

(30) Priority: 20.04.2009 IN CH08992009; 22.04.2009 IN CH09362009; 29.04.2009 IN CH09982009; 16.04.2010 IN DE09142010
(71) Applicant: Moser Baer India Limited, New Delhi 110020 (IN)
(72) Inventor: Singh, Jitender Pratap, 110020 New Delhi (IN); Malhi, Vijay, 110020 New Delhi (IN)
(74) Representative: Roche, Dermot

(57) **Abstract**

A miniature-sized storage device has been provided. The miniature-sized storage device includes one or more electrical components (104a,104b), at least one light source (106) electrically connected to at least one of the electrical components, and an encapsulating material (108) encapsulating the electrical components and the light source. At least one of the electrical components is capable of storing data. The encapsulating material encapsulates the light source in a manner that the light source is partially visible. The encapsulating material encapsulates the electrical components and the light source hermetically, thereby enabling water-resistance and robustness in the miniature-sized storage device. The miniature-sized storage device has the length ranging from 20 mm to 30 mm, the width ranging from 10 mm to 13 mm, and the height ranging from 1 mm to 2.5 mm.

## Description

### CROSS-REFERENCE TO RELATED APPLICATIONS

This application claims priority from co-pending Indian Patent Application No. 998/CHE/2009 filed on April 29, 2009, Indian Patent Application No. 936/CHE/2009 filed on April 22, 2009, Indian Patent Application No. 899/CHE/2009 filed on April 20, 2009 and Indian Patent Application No. 914/DEL/2010 filed on April 16, 2010. The entire disclosure of the prior applications is incorporated herein by reference.

### BACKGROUND

The embodiments herein relate, in general, to storage devices. More particularly, the embodiments relate to miniature-sized storage devices.

Universal Serial Bus (USB) flash drives are more common these days than any other portable storage devices. However, conventional USB flash drives are larger in size, which adds to inconvenience of end users. Whenever an attempt to miniaturize a USB flash drive is made, light indicators are sacrificed due to inherent complexity of the process of manufacturing miniaturized USB flash drives, as well as to reduce size. Additionally, conventional encapsulation techniques often encapsulate various components of the USB flash drive in a non-hermetic seal leading to loss of data due to rough handling of the USB flash drive. This makes such USB flash drives unsuitable for storing important data reliably. A light indicator typically indicates whether the USB flash drive is functioning properly, whether data is being accessed or not, etc. Removal of the light indicator causes inconvenience to the end users, who remain unaware of the state of the USB flash drive.

In light of the foregoing discussion, there is a need for a storage device that is small in size to provide ease of handling and use. In addition, the storage device should be highly reliable, shock resistant, water resistant and robust. Further, a light indicator should also be incorporated in the storage device for the convenience of end users.

### SUMMARY

An embodiment relates to a storage device that is miniature in size, and is easy to handle and use, compared to conventional storage devices.

Another embodiment relates to a storage device that is highly reliable, shock resistant, water resistant and robust, compared to conventional storage devices.

Embodiments herein provide a miniature-sized storage device that includes one or more electrical components, at least one light source electrically connected to at least one of the electrical components, and an encapsulating material encapsulating the electrical components and the light source. At least one of the electrical components is capable of storing data. The encapsulating material encapsulates the light source in a manner that the light source is partially visible. The encapsulating material encapsulates the electrical components and the light source hermetically, thereby enabling water-resistance, shock-resistance, robustness and high reliability in the miniature-sized storage device.

In accordance with an embodiment herein, the length of the miniature-sized storage device ranges from 20 mm to 30 mm, the width of the miniature-sized storage device ranges from 10 mm to 13 mm, and the height of the miniature-sized storage device ranges from 1 mm to 2.5 mm.

In addition, the miniature-sized storage device may be designed in several forms, due to its miniature size and robustness. In one embodiment herein, the miniature-sized storage device may be designed in the form of a chip that may be carried in a wallet. In another embodiment herein, the miniature-sized storage device may be designed in the form of a key ring that is easy to carry.

In an embodiment herein, the miniature-sized storage device is configured to be attached to a portable object.

In an embodiment herein, the miniature-sized storage device is a Chip-On-Board (COB) type device.

In an embodiment herein, the miniature-sized storage device is a Universal Serial Bus (USB) flash drive.

### BRIEF DESCRIPTION OF DRAWINGS

Embodiments herein will hereinafter be described in conjunction with the appended drawings provided to illustrate and not to limit the scope of the claims, wherein like designations denote like elements, and in which:
FIGs. 1A, 1B and 1C depict top, front and side views of a miniature-sized storage device, in accordance with an embodiment herein;
FIGs. 2A, 2B and 2C depict top, front and side views of the miniature-sized storage device, in accordance with an embodiment herein;
FIG. 3A depicts a top view of a casing enclosing a miniature-sized storage device;
FIG. 3B depicts a sectional view of a section A-A cut through the casing and the miniature-sized storage device, in accordance with an embodiment herein;
FIG. 4A and 4B depict top and front views of a miniature-sized storage device, in accordance with an embodiment herein;
FIG. 5A and 5B depict top and front views of the miniature-sized storage device, in accordance with an embodiment herein;
FIG. 6A and 6B depict top and front views of the miniature-sized storage device, in accordance with an embodiment herein;
FIG. 7 depicts a miniature-sized storage device enclosed by a casing, in accordance with an exemplary embodiment herein;
FIG. 8 depicts a miniature-sized storage device enclosed by a casing, in accordance with another exemplary embodiment herein;
FIG. 9 depicts a plurality of miniature-sized storage devices enclosed by a casing, in accordance with yet another exemplary embodiment herein; and
FIG. 10A depicts a casing, in accordance with an embodiment herein; FIG. 10B depicts how the casing may be attached to a string, in accordance with a specific embodiment herein; and FIG. 10C depicts how the casing may be attached to a key ring, in accordance with another specific embodiment herein.

### DETAILED DESCRIPTION

As used in the specification and claims, the singular forms "a", "an" and "the" include plural references unless the context clearly dictates otherwise. For example, the term "a light source" may include a plurality of light sources unless the context clearly dictates otherwise.

Embodiments herein provide a miniature-sized storage device. In the description of the embodiments herein, numerous specific details are provided, such as examples of components and/or mechanisms, to provide a thorough understanding of embodiments herein. One skilled in the relevant art will recognize, however, that an embodiment herein can be practiced without one or more of the specific details, or with other apparatus, systems, assemblies, methods, components, materials, parts, and/or the like. In other instances, well-known structures, materials, or operations are not specifically shown or described in detail to avoid obscuring aspects of embodiments herein.

### GLOSSARY

Base substrate: A base substrate is a substrate that provides mechanical support. The base substrate may, for example, be an electronic substrate that provides electrical connectivity. Examples of the base substrate include, but are not limited to, Printed Circuit Boards (PCBs), hybrid microcircuits, and extended PCBs. An extended PCB is a PCB including one or more conductive strips capable of facilitating a Universal Serial Bus (USB) connection.

Electrical component: An electrical component is a component of a storage device, and is placed on appropriate slots on a base substrate to achieve the objective of the storage device.

Light Source: A light source is a source of light. An example of the light source is a Light-Emitting Diode (LED). A light source may, for example, be used to indicate a current state of a storage device, in accordance with an embodiment herein.

Encapsulating material: An encapsulating material is a material used to encapsulate various electrical components and/or a light source of a storage device, so as to protect the storage device from external factors, such as heat, moisture and scratches. The encapsulating material may, for example, include epoxy resin.

Chip-On-Board (COB) type storage device: A COB type storage device is a storage device manufactured by a COB process. A COB process includes directly placing a bare semiconductor die on an electronic substrate, and electrically connecting the bare semiconductor die to appropriate bond pads on the electronic substrate.

In accordance with an embodiment herein, a miniature-sized storage device includes one or more electrical components, at least one light source electrically connected to at least one of the electrical components, and an encapsulating material encapsulating the electrical components and the light source. At least one of the electrical components is capable of storing data. The encapsulating material encapsulates the light source in a manner that the light source is partially visible. The encapsulating material encapsulates the electrical components and the light source hermetically, thereby enabling water-resistance and robustness in the miniature-sized storage device.

In accordance with an embodiment herein, the length of the miniature-sized storage device ranges from 20 mm to 30 mm, the width of the miniature-sized storage device ranges from 10 mm to 13 mm, and the height of the miniature-sized storage device ranges from 1 mm to 2.5 mm.

In addition, the miniature-sized storage device may be designed in several forms, due to its miniature size and robustness. In one embodiment herein, the miniature-sized storage device may be designed in the form of a chip that may be carried in a wallet. In another embodiment herein, the miniature-sized storage device may be designed in the form of a key ring that is easy to carry.

In an embodiment herein, the miniature-sized storage device is configured to be attached to a portable object.

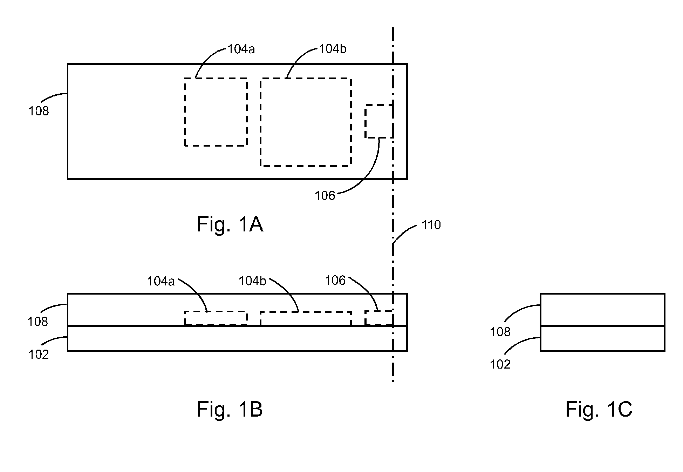

FIGs. 1A, 1B and 1C depict top, front and side views of a miniature-sized storage device, in accordance with an embodiment herein. The miniature-sized storage device includes a base substrate 102, one or more electrical components, shown as an electrical component 104a and an electrical component 104b, and at least one light source, shown as a light source 106. Electrical component 104a and electrical component 104b are hereinafter referred as electrical components 104. At least one of electrical components 104 is capable of storing data.

Base substrate 102 may include a plurality of slots (not shown in the figure) to facilitate placing of electrical components 104 and light source 106. In accordance with an embodiment herein, electrical components 104 and light source 106 are placed on the same surface of base substrate 102. Light source 106 is electrically connected to at least one of electrical components 104. Base substrate 102 may include one or more embedded connectors (not shown in the figure) for electrically connecting electrical components 104 and light source 106 in a pre-defined manner. Electrical components 104 and light source 106 may, for example, be thermally and electrically bonded to base substrate 102 using an electrically-conductive paste. In addition, electrical components 104 may be wire-bonded to preset bond pads on base substrate 102 using one or more electrical connectors.

The miniature-sized storage device also includes an encapsulating material 108 molded over electrical components 104 and light source 106. Encapsulating material 108 encapsulates electrical components 104 and light source 106, as shown in FIGs. 1A-1C. In accordance with an embodiment herein, a portion of encapsulating material 108 molded around light source 106 is removed. In accordance with an embodiment herein, base substrate 102 and encapsulating material 108 are cut across a plane represented by a line 110.

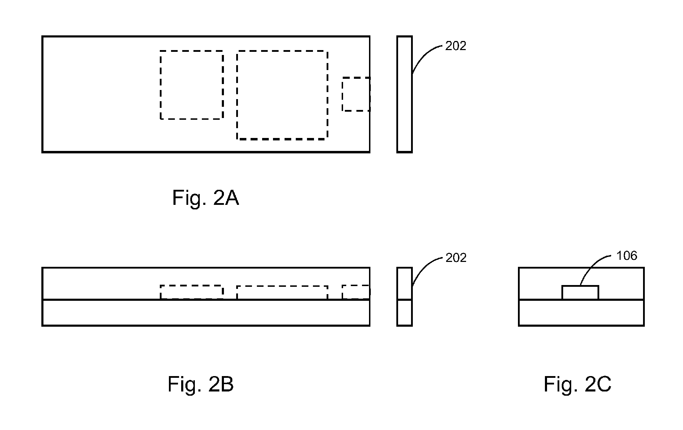

FIGs. 2A, 2B and 2C depict top, front and side views of the miniature-sized storage device, after base substrate 102 and encapsulating material 108 are cut, in accordance with an embodiment herein. A portion 202 of base substrate 102 and encapsulating material 108 is removed, such that light source 106 is uncovered at least partially, as shown. Consequently, light source 106 is partially visible. This facilitates transmission of light emitted from light source 106.

In accordance with an embodiment herein, a portion of light source 106 is cut across a pre-defined plane, such that any traces of encapsulating material 108 left over that portion of light source 106 are removed. This further enhances the transmission of light emitted from light source 106.

Light source 106 may, for example, include at least one LED. In accordance with an embodiment herein, light source 106 is capable of indicating a pre-defined state of the miniature-sized storage device. The pre-defined state may, for example, include at least one of: the miniature-sized storage device being connected to a USB, the miniature-sized storage device being ready to be operated on, the miniature-sized storage device performing data read and/or write, or an occurrence of an error. In addition, light source 106 may indicate different states of the miniature-sized storage device, for example, by emitting light of different colors, or by flickering.

In accordance with an embodiment herein, the miniature-sized storage device is a USB flash drive. In such a case, light source 106 may indicate whether the USB flash drive is connected to a USB.

In accordance with an embodiment herein, light source 106 is placed at a preset location on base substrate 102. For example, light source 106 may be located at a periphery associated with base substrate 102, as shown.

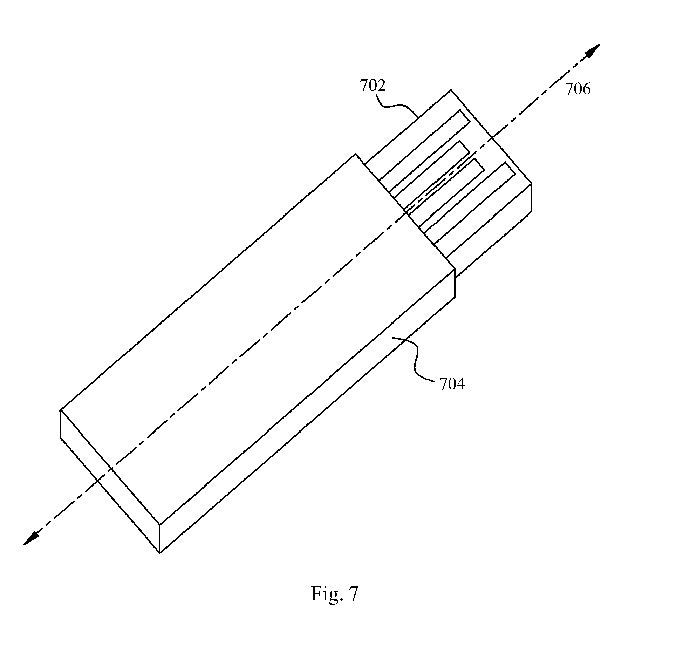

FIGs. 1A-1C and 2A-2C depict various stages in which the miniature-sized storage device is manufactured, in accordance with an embodiment herein. In accordance with an embodiment herein, the miniature-sized storage device is a COB type storage device. In such a case, at least one of electrical components 104 may be a bare semiconductor die. Additionally, base substrate 102 may, for example, be an extended PCB that includes one or more conductive strips capable of facilitating a USB connection. The COB type storage device is manufactured by a COB process, which requires less space. Therefore, a base substrate of a small size may be used. The COB type storage device so manufactured is miniature in size. For example, the dimensions of the miniature-sized storage device may be as follows: the length ranging from 20 mm to 30 mm, the width ranging from 10 mm to 13 mm, and the height ranging from 1 mm to 2.5 mm. Consequently, the miniature-sized storage device may be designed in several forms. In one example, the miniature-sized storage device may be designed in the form of a chip that may be easily carried in a wallet. A few other examples have been depicted in FIGs. 7, 8, 9, 10A-10C.

It should be noted here that the miniature-sized storage device so manufactured is not limited to a specific shape or size of its components. FIGs. 1A-1C and 2A-2C are merely an example, which should not unduly limit the scope of the claims herein. One of ordinary skill in the art would recognize many variations, alternatives, and modifications of embodiments herein. For example, encapsulating material 108 may be molded over more than one surface of base substrate 102. In accordance with an alternative embodiment herein, only encapsulating material 108 may be cut across the plane to uncover light source 106 partially.

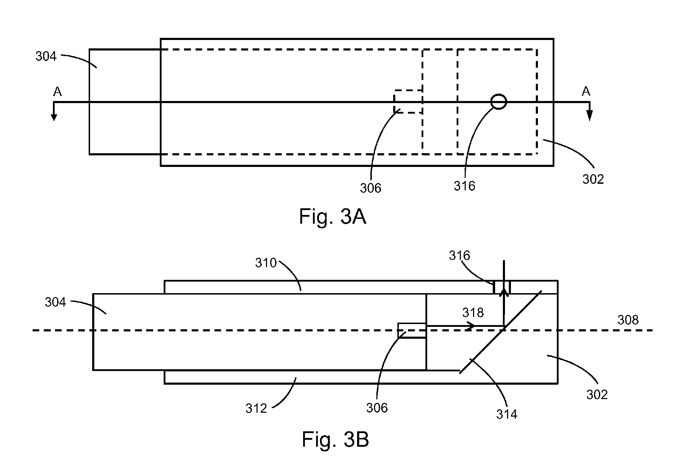

FIG. 3A depicts a top view of a casing 302 enclosing a miniature-sized storage device 304; FIG. 3B depicts a sectional view of a section A-A cut through casing 302 and miniature-sized storage device 304, in accordance with an embodiment herein. Miniature-sized storage device 304 includes one or more electrical components (not shown in the figure) and a light source 306 placed on a base substrate (not shown in the figure). Light source 306 is located at a periphery associated with miniature-sized storage device 304, such that light emitted from light source 306 travels in a direction parallel to a longitudinal axis 308 of miniature-sized storage device 304, as shown in FIG. 3B. Casing 302 includes a first covering component 310 and a second covering component 312. First covering component 310 includes one or more first portions (not shown in the figure) at a first periphery associated with first covering component 310, while second covering component 312 includes one or more second portions (not shown in the figure) at a second periphery associated with second covering component 312. The first portions and the second portions substantially complement each other, and are engaged together mechanically to enclose at least one section of miniature-sized storage device 304 in between first covering component 310 and second covering component 312. The at least one section of miniature-sized storage device 304 includes light source 306, as shown in FIG. 3B.

Second covering component 312 also includes one or more reflecting surfaces, shown as a reflecting surface 314. Reflecting surface 314 is adapted to reflect light emitted from light source 306 towards a pre-defined view zone 316 through which light reflected from reflecting surface 314 is visible to a viewer, as shown in FIG. 3B. In accordance with an embodiment herein, reflecting surface 314 is inclined at a pre-defined angle with respect to longitudinal axis 308 of miniature-sized storage device 304. The pre-defined angle may, for example, range from 15 degrees to 50 degrees.

Reflecting surface 314 may, for example, be a smooth, polished surface. In addition, reflecting surface 314 may be coated with a reflective material to enhance the reflectivity of reflecting surface 314, in accordance with an additional embodiment herein.

In a specific embodiment herein, casing 302 is made of an opaque material. In such a case, reflecting surface 314 may, for example, be a smooth, polished surface of the opaque material. In such a case, the reflection efficiency of reflecting surface 314 may be approximately equal to 90 percent.

In another specific embodiment herein, casing 302 is made of a translucent material. In such a case, reflecting surface 314 may, for example, be a smooth, polished surface of the translucent material. In such a case, the reflection efficiency of reflecting surface 314 may be approximately equal to 50 percent.

In accordance with an embodiment herein, at least one of first covering component 310 or second covering component 312 includes pre-defined view zone 316. With reference to FIG. 3B, first covering component 310 includes pre-defined view zone 316. Pre-defined view zone 316 may, for example, include at least one of a hole, a transparent portion, or a translucent portion. A light ray 318 is reflected from reflecting surface 314 and is transmitted through pre-defined view zone 316, as shown in FIG. 3B.

In accordance with an embodiment herein, pre-defined view zone 316 is a hole covered with a transparent material, such as glass or plastic. For example, the hole may be covered with a transparent lens. The transparent lens may be coated with an anti-reflective coating, so as to avoid transmission losses due to reflection and/or total internal reflection.

In accordance with another embodiment herein, first covering component 310 is made of a translucent material. In such a case, light reflected from reflecting surface 314 is visible to a viewer through a portion of first covering component 310 that acts as pre-defined view zone 316.

In accordance with an embodiment herein, pre-defined view zone 316 may have a shape that is curved, polygonal, or a combination thereof. The size, the shape and/or the location of pre-defined view zone 316 may be chosen, so as to maximize the ratio of the amount of light viewed at pre-defined view zone 316 and the amount of light emitted from light source 306. Accordingly, the size and/or the shape of pre-defined view zone 316 may depend on at least one of: the size and/or shape of first covering component 310, the location of pre-defined view zone 316 on first covering component 310, or the pre-defined angle at which reflecting surface 314 is inclined, in accordance with an embodiment herein.

In accordance with an embodiment herein, miniature-sized storage device 304 includes one or more recessed portions (not shown in the figure) at the periphery associated with miniature-sized storage device 304, and at least one of first covering component 310 or second covering component 312 includes one or more protruding portions (not shown in the figure) at an inner periphery, such that the recessed portions and the protruding portions engage together mechanically. Accordingly, the shape of the recessed portions and the protruding portions may be chosen in a manner that they substantially complement each other.

Consider, for example, that a semicircular recessed portion is cut from miniature-sized storage device 304. Accordingly, at least one of first covering component 310 or second covering component 312 may be molded with a semicircular protruding portion that substantially complements the semicircular recessed portion. First covering component 310 and second covering component 312 may be molded from, for example, at least one of acrylic, polyurethane, thermoplastic rubber, or plastic in any desired shape and/or size.

In accordance with an additional embodiment herein, first covering component 310 and second covering component 312 are attached to miniature-sized storage device 304 through a gluing process or an ultrasonic welding process.

It should be noted here that casing 302 is not limited to a specific shape or size of first covering component 310 and second covering component 312. FIGs. 3A-3B are merely an example, which should not unduly limit the scope of the claims herein. One of ordinary skill in the art would recognize many variations, alternatives, and modifications of embodiments herein.

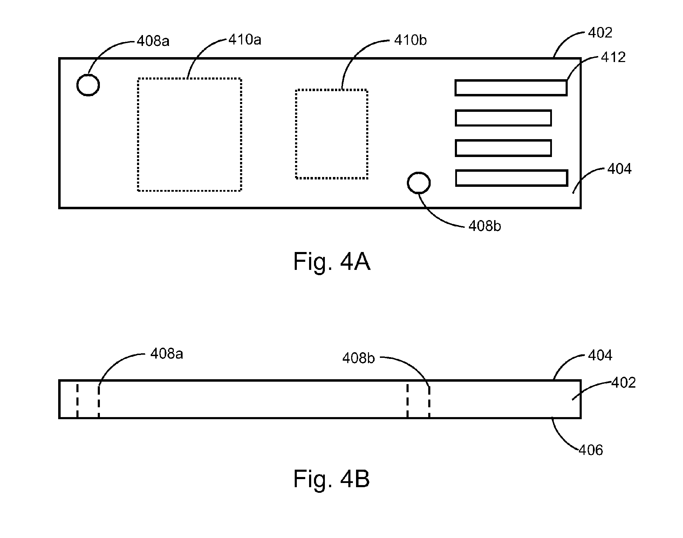

FIGs. 4A-4B, 5A-5B and 6A-6B depict top and front views of a miniature-sized storage device, and various stages in which the miniature-sized storage device is manufactured, in accordance with an embodiment herein. The miniature-sized storage device includes a base substrate 402 having a first surface 404 and a second surface 406. In accordance with an embodiment herein, base substrate 402 includes one or more perforations, shown as a perforation 408a and a perforation 408b. Perforation 408a and perforation 408b are hereinafter referred as perforations 408. Perforations 408 are capable of facilitating adhesion of an encapsulating material over first surface 404 of base substrate 402.

In accordance with a specific embodiment herein, at least one of perforations 408 is capable of facilitating adhesion of the encapsulating material over second surface 406 of base substrate 402.

In accordance with an embodiment herein, at least one of perforations 408 is coated with a coat of an affinitive material. The affinitive material is a material having an affinity for the encapsulating material. Accordingly, a suitable affinitive material may be chosen depending on the encapsulating material to be used. In accordance with an embodiment herein, the encapsulating material includes at least one of: epoxy resin, silicone, acrylic and polyurethane. In accordance with an embodiment herein, the affinitive material includes at least one of: silver, silver alloy, copper, copper alloy, nickel, nickel alloy, palladium, gold, gold alloy, and black oxide.

In accordance with an embodiment herein, perforations 408 are formed at preset locations on base substrate 402. For example, perforations 408 may be located at a periphery of base substrate 402.

In addition, perforations 408 may be formed in any desired shape and/or size. For example, perforations 408 may have a shape that is curved, polygonal, or a combination thereof. With reference to FIG. 4A, perforations 408 are circular in shape.

The size of perforations 408 may depend on the size of base substrate 402. The size of perforations 408 may also depend on the number, the size and the location of various components to be placed on base substrate 402. In addition, the size of perforations 408 may also depend on their location on base substrate 402.

In accordance with an embodiment herein, base substrate 402 is an electronic substrate that includes one or more slots, shown as a slot 410a and a slot 410b, to facilitate placing of electrical components. Slot 410a and slot 410b are hereinafter referred as slots 410. In accordance with an embodiment herein, at least one of slots 410 is formed on first surface 404 of base substrate 402.

In accordance with an embodiment herein, base substrate 402 is an extended PCB that includes one or more conductive strips 412 capable of facilitating a USB connection.

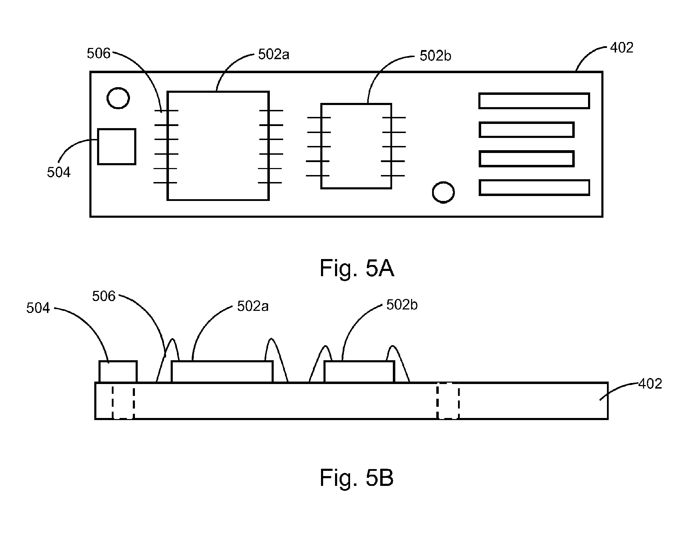

With reference to FIG. 5A, the miniature-sized storage device includes an electrical component 502a and an electrical component 502b placed on slot 410a and slot 410b on base substrate 402, respectively. Electrical component 502a and electrical component 502b are hereinafter referred as electrical components 502. At least one of electrical components 502 is capable of storing data, in accordance with an embodiment herein.

In addition, the miniature-sized storage device includes a light source 504 placed at a periphery of base substrate 402, as shown.

Base substrate 402 includes one or more embedded connectors (not shown in the figure) for electrically connecting electrical components 502 and light source 504 in a pre-defined manner, in accordance with an embodiment herein.

Electrical components 502 and light source 504 may, for example, be thermally bonded to base substrate 402 using an electrically-conductive paste. In addition, electrical components 502 may be wire bonded to preset bond pads on base substrate 402 using wires 506, as shown in FIG. 5A.

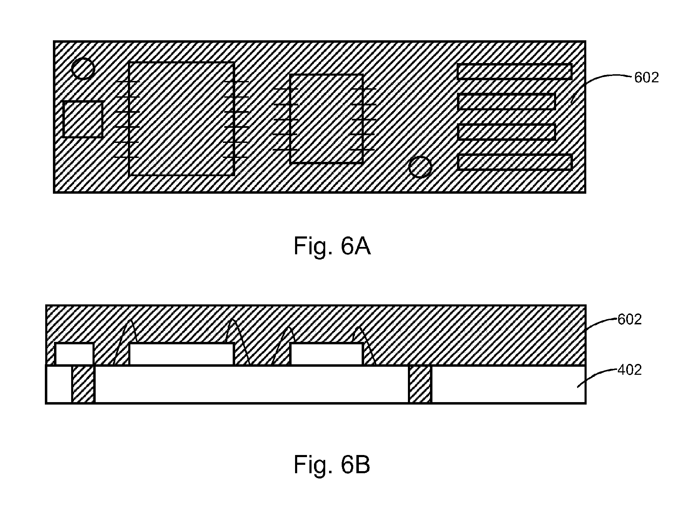

With reference to FIGs. 6A and 6B, the miniature-sized storage device includes an encapsulating material 602 molded over first surface 404. Consequently, encapsulating material 602 fills in and adheres to perforations 408, and encapsulates electrical components 502 and light source 504.

As mentioned above, the affinitive material has an affinity for encapsulating material 602. Therefore, the coat of the affinitive material enhances the adhesion of encapsulating material 602 to base substrate 402. Consequently, encapsulating material 602 encapsulates electrical components 502 and light source 504 hermetically. Encapsulating material 602 protects electrical components 502 and light source 504 from mechanical and chemical damage, thereby enabling water-resistance, shock-resistance and robustness in the miniature-sized storage device. This makes the miniature-sized storage device highly reliable.

In accordance with a specific embodiment herein, encapsulating material 602 is also molded over second surface 406 of base substrate 402.

It should be noted here that the miniature-sized storage device so manufactured is not limited to a specific shape or size of its components. FIGs. 4A-B, 5A-B and 6A-B are merely an example, which should not unduly limit the scope of the claims herein. One of ordinary skill in the art would recognize many variations, alternatives, and modifications of embodiments herein.

FIG. 7 depicts a miniature-sized storage device 702 enclosed by a casing 704, in accordance with an exemplary embodiment herein. Miniature-sized storage device 702 may be slided into and out of casing 704 along a longitudinal axis 706 of miniature-sized storage device 702, as shown. For example, miniature-sized storage device 702 may be slided out of casing 704 for use, and may be slided into casing 704 after use.

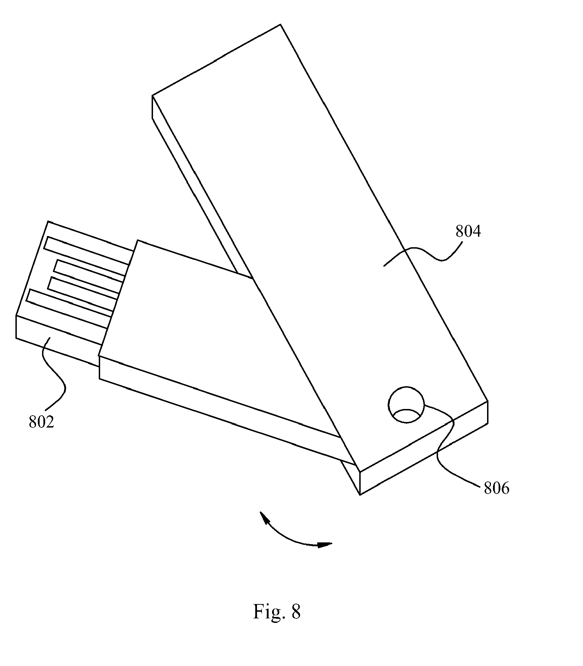

FIG. 8 depicts a miniature-sized storage device 802 enclosed by a casing 804, in accordance with another exemplary embodiment herein. Miniature-sized storage device 802 may be rotated about a pivot 806 with respect to casing 804, as shown. For example, miniature-sized storage device 802 may be rotated in a direction opposite to casing 804 for use, and may be rotated back into casing 804 after use.

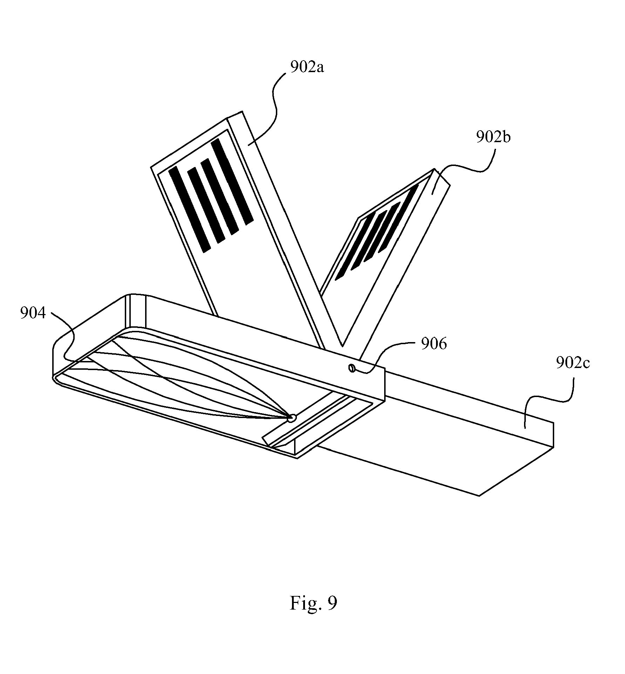

FIG. 9 depicts a miniature-sized storage device 902a, a miniature-sized storage device 902b and a miniature-sized storage device 902c enclosed by a casing 904, in accordance with yet another exemplary embodiment herein. Miniature-sized storage device 902a, miniature-sized storage device 902b and miniature-sized storage device 902c may be flipped open about a pivot 906, as shown.

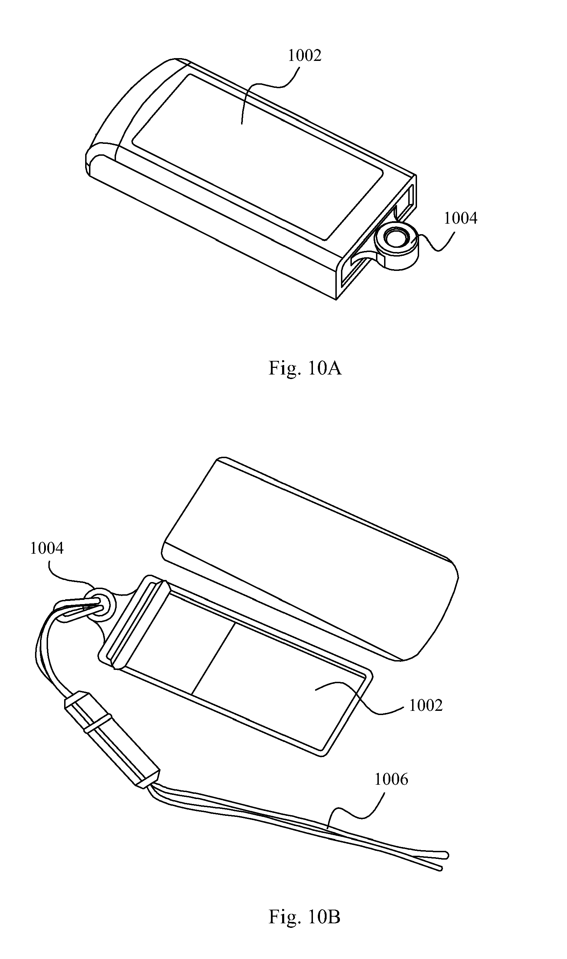

FIG. 10A depicts a casing 1002, in accordance with an embodiment herein. Casing 1002 includes a hole 1004, which configures casing 1002 to be attached to a portable object, such as a string or a key ring. Casing 1002 is suitable for enclosing a miniature-sized storage device, which may be easily carried along with the portable object.

FIG. 10B depicts how casing 1002 may be attached to a string 1006, in accordance with a specific embodiment herein. String 1006 facilitates easy handling and carrying of a miniature-sized storage device enclosed in casing 1002.

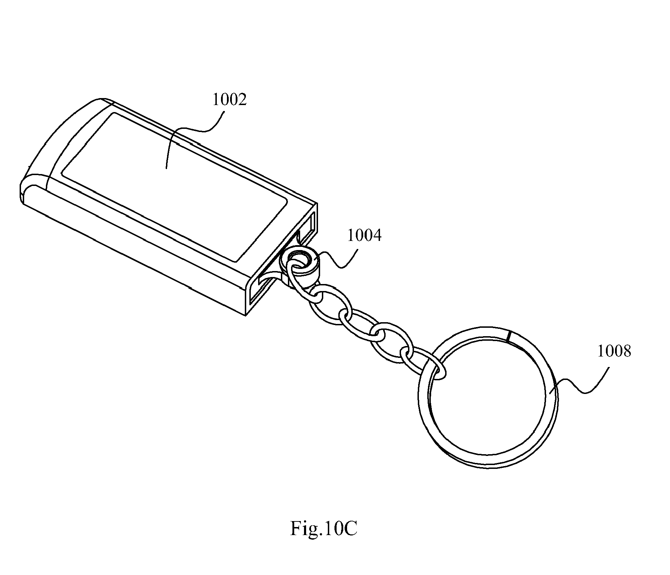

FIG. 10C depicts how casing 1002 may be attached to a key ring 1008, in accordance with another specific embodiment herein. Key ring 1008 facilitates easy handling and carrying of a miniature-sized storage device enclosed in casing 1002.

Embodiments herein provide a miniature-sized storage device. In an embodiment herein, the miniature-sized storage device has the length ranging from 20 mm to 30 mm, the width ranging from 10 mm to 13 mm, and the height ranging from 1 mm to 2.5 mm. The miniature-sized storage device is easy to handle and use.

In addition, the miniature-sized storage device may be designed in several forms, due to its miniature size and robustness. In one example, the miniature-sized storage device may be designed in the form of a chip that may be carried in a wallet. In another example, the miniature-sized storage device may be designed in the form of a key ring that is easy to carry.

This application may disclose several numerical range limitations that support any range within the disclosed numerical ranges even though a precise range limitation is not stated verbatim in the specification because the embodiments of the invention could be practiced throughout the disclosed numerical ranges. Finally, the entire disclosure of the patents and publications referred in this application, if any, are hereby incorporated herein in entirety by reference.

Therefore, the foregoing is considered as illustrative only of the principles of the invention. Further, since numerous modifications and changes will readily occur to those skilled in the art, it is not desired to limit the invention to the exact construction and operation shown and described, and accordingly, all suitable modifications and equivalents may be resorted to, falling within the scope of the invention.

## Claims

1. A miniature-sized storage device comprising:
one or more electrical components, at least one of said electrical components being capable of storing data;
at least one light source electrically connected to at least one of said electrical components; and
an encapsulating material encapsulating said electrical components and said light source, such that said light source is partially visible, said encapsulating material enabling water-resistance and robustness in said miniature-sized storage device,
wherein the length of said miniature-sized storage device ranges from 20 mm to 30 mm, the width of said miniature-sized storage device ranges from 10 mm to 13 mm, and the height of said miniature-sized storage device ranges from 1 mm to 2.5 mm.

2. The miniature-sized storage device of claim 1 is in the form of at least one of: a chip and a key ring.

3. The miniature-sized storage device of claim 1 is configured to be attached to a portable object.

4. The miniature-sized storage device of claim 1, wherein said light source comprises at least one Light-Emitting Diode (LED).

5. The miniature-sized storage device of claim 1 is a Chip-On-Board (COB) type storage device.

6. A miniature-sized storage device comprising:
a base substrate;
one or more electrical components placed on said base substrate, at least one of said electrical components being capable of storing data;
at least one light source placed on said base substrate, said light source being electrically connected to at least one of said electrical components; and
an encapsulating material molded over said electrical components and said light source, such that said light source is partially visible, wherein said encapsulating material encapsulates said electrical components and said light source hermetically, thereby making said miniature-sized storage device water-resistant and robust,
wherein the length of said miniature-sized storage device ranges from 20 mm to 30 mm, the width of said miniature-sized storage device ranges from 10 mm to 13 mm, and the height of said miniature-sized storage device ranges from 1 mm to 2.5 mm.

7. The miniature-sized storage device of claim 6 is in the form of at least one of: a chip and a key ring.

8. The miniature-sized storage device of claim 6 is configured to be attached to a portable object.

9. The miniature-sized storage device of claim 6, wherein said light source comprises at least one Light-Emitting Diode (LED).

10. The miniature-sized storage device of claim 6 is a Chip-On-Board (COB) type storage device.

11. A miniature-sized storage device comprising:
a base substrate;
one or more electrical components placed on said base substrate, at least one of said electrical components being capable of storing data;
an encapsulating material molded over said electrical components, wherein said encapsulating material encapsulates said electrical components hermetically, thereby making said miniature-sized storage device water-resistant and robust,
wherein the length of said miniature-sized storage device ranges from 20 mm to 30 mm, the width of said miniature-sized storage device ranges from 10 mm to 13 mm, and the height of said miniature-sized storage device ranges from 1 mm to 2.5 mm.

12. The miniature-sized storage device of claim 11 further comprising at least one light source placed on said base substrate, said light source being electrically connected to at least one of said electrical components, wherein said encapsulating material is molded over said light source, such that said light source is partially visible, and said encapsulating material encapsulates said light source hermetically.

13. The miniature-sized storage device of claim 12, wherein said light source comprises at least one Light-Emitting Diode (LED).

14. The miniature-sized storage device of claim 11 is in the form of at least one of: a chip and a key ring.

15. The miniature-sized storage device of claim 11 is configured to be attached to a portable object.
